(19) Europäisches Patentamt
European Patent Office
Office européen des brevets

(11) EP 2 190 101 A1

(12) EUROPEAN PATENT APPLICATION
published in accordance with Art. 153(4) EPC

(43) Date of publication:
26.05.2010 Bulletin 2010/21

(51) Int Cl.:
$H02J\ 7/02^{(2006.01)}$     $H01M\ 10/44^{(2006.01)}$

(21) Application number: 08790210.2

(22) Date of filing: 16.07.2008

(86) International application number:
PCT/JP2008/001908

(87) International publication number:
WO 2009/037801 (26.03.2009 Gazette 2009/13)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 18.09.2007 JP 2007240561

(71) Applicant: Panasonic Corporation
Kadoma-shi
Osaka 571-8501 (JP)

(72) Inventors:
• SUGIYAMA, Shigeyuki
Osaka-shi
Osaka 540-6207 (JP)
• AOKI, Mamoru
Osaka-shi
Osaka 540-6207 (JP)

(74) Representative: Schwabe - Sandmair - Marx
Patentanwälte
Stuntzstraße 16
81677 München (DE)

(54) **POWER SUPPLY SYSTEM**

(57)     A power supply system includes at least one aqueous secondary battery and at least one nonaqueous secondary battery having a smaller per-init battery capacity than the aqueous secondary battery. This power supply system further includes at least one forced discharge unit capable of forcibly discharging each nonaqueous secondary battery, and a control unit for measuring the voltage of each nonaqueous secondary battery and, when the voltage of the nonaqueous secondary battery reaches a forced discharge start voltage Va, forcibly discharges each nonaqueous secondary battery, using the forced discharge unit until a forced discharge end voltage is reached.

FIG. 1

**Description**

Technical Field

The present invention relates to a power supply system having a plurality of secondary batteries.

Background Art

Conventionally, two-wheeled vehicles, three-wheeled vehicles and vehicles with four wheels or more are mounted with a lead storage battery for starting the power system and driving the electrical circuit and electrical equipment. Although a lead storage battery is inexpensive, since the storage energy density is small, the weight and volume thereof are large. From the perspective of mileage and automotive performance of vehicles, the ligher weight and miniaturization of the foregoing weight and volume are being demanded. As an improvement strategy, there is a method of adopting a nickel cadmium secondary battery, a nickel hydride secondary battery, a lithium ion secondary battery, or a lithium polymer secondary battery having large storage energy density. Moreover, in order to resolve the various problems in cases of configuring an assembled battery with a single type of battery, proposed is an assembled battery that combined different types of batteries (for example, refer to Patent Document 1).

Meanwhile, in order to charge the lead storage battery, for instance, charging methods such as the constant voltage charge method of charging at a constant voltage and the constant current constant voltage (CCCV: Constant Current Constant Voltage) charge method of performing the constant voltage charge after the constant current charge are employed. When performing the constant voltage charge, the charging current flowing in the secondary battery is detected while applying a constant voltage to the secondary battery, and the charge is ended when the charging current becomes a predetermined charge cut-off current value or less.

Nevertheless, if an aqueous secondary battery such as a nickel cadmium secondary battery or a nickel hydride secondary battery is charged with a constant voltage, the open circuit voltage of the cell will drop due to the rise in temperature caused by the generation of oxygen as the side reaction near its full charge, and the charging current will increase. Consequently, since the charging current will not become a charge cut-off current value or less, the constant voltage charge cannot be completed, and the charging will continue and result in a state of overcharge. As a result, leakage will occur due to the overcharge, and the battery function will deteriorate. Thus, with a vehicle comprising a charging circuit for a lead storage battery, there was an inconvenience in not being able to mount an aqueous secondary battery in substitute for the lead storage battery.

Moreover, a nonaqueous secondary battery such as a lithium ion secondary battery and a lithium polymer secondary battery can be charged based on the constant current constant voltage (CCCV) charging method as with the lead storage battery. Nevertheless, if this kind of nonaqueous secondary battery is mounted on a vehicle comprising a charging circuit for a lead storage battery in substitute for the lead storage battery, there was a drawback in that sufficient charging cannot be performed since the lead storage battery and the nonaqueous secondary battery have different a charging voltage.

For example, a DC 12V power lead storage battery is subject to a constant voltage charge at 14.5V. Such being the case, when charging an assembled battery, in which a plurality of lithium ion secondary batteries are serially connected, using a charging circuit for charging the lead storage battery, the charging voltage per lithium ion secondary battery will be a voltage that is obtained by dividing 14.5V by the number of lithium ion secondary batteries. For example, with an assembled battery in which three lithium ion secondary batteries are serially connected, the charging voltage per lithium ion secondary battery will be 14.5V/3 = 4.83V.

Meanwhile, as the charging voltage upon subjecting a lithium ion secondary battery to a constant voltage charge, 4.2V as the open voltage in the fully charged state of the lithium ion secondary battery is used. Such being the case, when charging an assembled battery in which three lithium ion secondary batteries are serially connected using a charging circuit for the lead storage battery, the charging voltage will be too high, and there were inconveniences such as deterioration in characteristics, malfunction and safety issues caused by the overcharge.

In addition, with an assembled battery in which four lithium ion secondary batteries are serially connected, the charging voltage per lithium ion secondary battery will be 14.5V/4 = 3.63V, and the charging voltage will be too low in relation to 4.2V and the depth of charge (SOC: State of Charge) will only reach approximately 50% or less, and there was an inconvenience that the battery capacity of the secondary battery could not be leveraged.

Moreover, the technology described in Patent Document 1 is attempting to use the characteristics of the increase in heat generation near the full charge of the aqueous secondary battery and thereby determine that the full charge has been reached based on the temperature in an assembled battery in which an aqueous secondary battery and a nonaqueous secondary battery coexist. Nevertheless, with a charging circuit for constant voltage charge such as the charging circuit for a lead storage battery, the full charge is determined based on the charging current and the charging is ended thereby. Thus, if the assembled battery described in Patent Document 1 is charged with a charging circuit for constant voltage charge, the charge cannot be completed, and there were inconveniences such as deterioration in characteristics, malfunction and safety issues caused by the overcharge. In addition, since the aqueous secondary battery generates heat near its full charge, there was also an inconvenience in that the nonaqueous secondary battery combined with the aqueous secondary battery would deteriorate as a result of being heated.

Patent Document 1: Japanese Patent Application Laid-open No. H9-180768

Disclosure of the Invention

The present invention was devised in view of the foregoing circumstances, and an object thereof is to provide an assembled battery in which the possibility of overcharge can be reduced and the depth of charge at the end of the charge can be easily increased even when it is charged with a charging circuit for a constant voltage charge, and a power supply using such an assembled battery.

The power supply system according to one aspect of the present invention includes at least one aqueous secondary battery and at least one nonaqueous secondary battery having a smaller per-unit battery capacity than the aqueous secondary battery. With the aqueous secondary battery and the nonaqueous secondary battery being serially connected, this power supply system further includes at least one forced discharge unit capable of forcibly discharging each nonaqueous secondary battery, and a control unit for individually measuring the voltages of the nonaqueous secondary battery and the aqueous secondary battery, and when the voltage of the nonaqueous secondary battery reaches a forced discharge start voltage Va, forcibly discharges each nonaqueous secondary battery using the forced discharge unit until a forced discharge end voltage Vb is reached.

According to the foregoing configuration, when the assembled battery configured from an aqueous secondary battery and a nonaqueous secondary battery is charged based on a constant voltage charge, since the charging current flowing in the aqueous secondary battery and the charging current flowing in the nonaqueous secondary battery are equal, the nonaqueous secondary battery with a smaller battery capacity will approach full charge first, the charging current will decrease, and the constant voltage charge will end. Then, at the time when the charging is ended, since the aqueous secondary battery having a larger battery capacity than the nonaqueous secondary battery has not yet reached full charge, the possibility of its overcharge can be reduced. Moreover, in comparison to cases of serially connecting a plurality of secondary batteries of the same type, with the combination of the aqueous secondary battery and the nonaqueous secondary battery having different battery characteristics, it will be easier to adapt the charging characteristics of the overall assembled battery to a predetermined charging voltage and increase the depth of charge at the end of the charge.

In addition, with the power supply system of the present invention, a control unit individually measures the voltages of the nonaqueous secondary battery and the aqueous secondary battery, and when the voltage of the nonaqueous secondary battery reaches a forced discharge start voltage Va, forcibly discharges the nonaqueous secondary batteries using the forced discharge unit until a forced discharge end voltage Vb is reached. If the aqueous secondary battery configuring the assembled battery is subject to a voltage drop due to a short circuit or the like, if the constant voltage charge to the assembled battery is continued, there is a possibility that the nonaqueous secondary battery configuring the assembled battery may be overcharged. According to the power supply system of the present invention, even if the foregoing problem occurs, since the nonaqueous secondary battery can be controlled so that it will not exceed the forced discharge start voltage Va, greater safety can be ensured.

The object, features and advantages of the present invention will become clearer based on the ensuing detailed explanation and attached drawings.

Brief Description of the Drawings

[Fig. 1] Fig. 1 is a block diagram showing an example of a practical application of the power supply system according to an embodiment of the present invention.

[Fig. 2] Fig. 2 is a graph showing an example of the charging time, the terminal voltage of the respective lithium ion secondary batteries and the respective nickel hydride secondary batteries, and the and total voltage Vc upon subjecting the assembled battery to constant current constant voltage charge.

Best Mode for Carrying Out the Invention

An embodiment of the present invention is now explained with reference to the attached drawings.

The power supply system of the present invention includes an aqueous secondary battery and a nonaqueous secondary battery having a smaller per-unit battery capacity than the aqueous secondary battery, and the aqueous secondary battery and the nonaqueous secondary battery are serially connected. This power supply system comprises a plurality of forced discharge units capable of forcibly discharging each nonaqueous secondary battery individually, and a control unit for individually measuring the voltage of the nonaqueous secondary battery and the aqueous secondary battery and, when the voltage of the nonaqueous secondary battery reaches a forced discharge start voltage Va, forcibly discharging the nonaqueous secondary batteries individually using the forced discharge unit until a forced discharge end voltage Vb is reached.

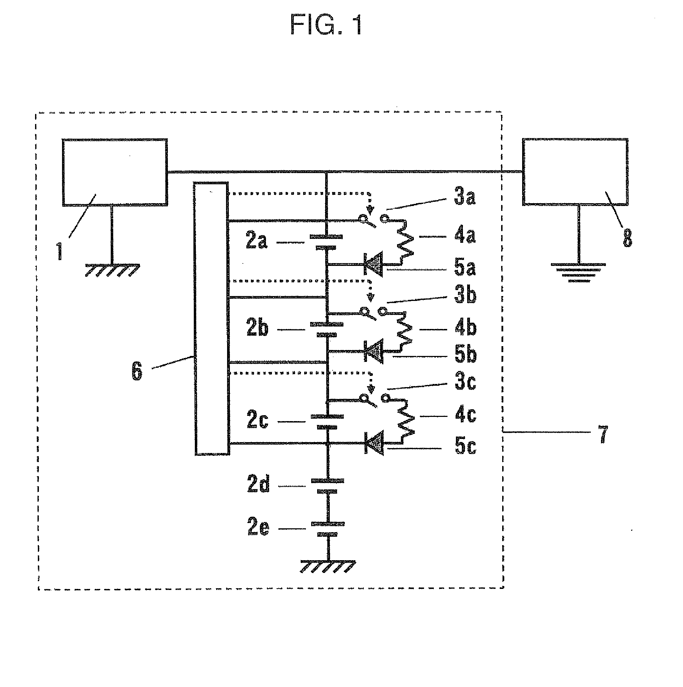

Fig. 1 is a block diagram showing the configuration of a vehicle self-starter power supply configured from three nonaqueous secondary batteries and two aqueous secondary batteries as an example of a practical application of the power supply system of the present invention. The power supply system 7 comprises, as shown in Fig. 1, a generator 1, an assembled battery configured from lithium ion secondary batteries (nonaqueous secondary batteries) 2a, 2b and 2c and nickel hydride secondary batteries (aqueous secondary batteries) 2d and 2e, a plurality of forced discharge units capable of forcibly discharging each of the lithium ion secondary batteries 2a, 2b and 2c, and a control unit 6 for individually measuring the voltage of the lithium ion secondary batteries 2a, 2b and 2c and, when the voltage of the lithium ion secondary batteries reaches a forced discharge start voltage Va, forcibly discharging the lithium ion secondary batteries using the forced discharge unit until a forced discharge end voltage Vb is reached. Here, the lithium ion secondary batteries 2a, 2b and 2c each have a smaller battery capacity than the nickel hydride secondary batteries 2d and 2e. Moreover, the forced discharge unit is configured from a forced discharge circuit, and a switch 3a, 3b or 3c for connecting the lithium ion secondary battery 2a, 2b or 2c and the forced discharge circuit based on a command from the control unit 6. The forced discharge circuit is configured from a resistor 4a, 4b or 4c and a diode 5a, 5b or 5c. The case of using a constant voltage-type generator 1 is now explained in detail.

The generator 1 is a generator for charging, for example, a vehicle lead storage battery based on a constant current constant voltage (CCCV), and is configured, for instance, from a vehicle ECU (Electric Control Unit) or the like. The generator 1 comprises, for example, a voltage sensor, a current sensor, a charging current supply circuit, and a generator control unit (not shown).

The charging current supply circuit comprises, for instance, a rectification circuit and a switching power circuit for generating a charging current and a charging voltage for charging the lead storage battery from the power that is generated in the vehicle. The charging current supply circuit is connected to the current sensor and the connecting terminal via an electrical wire.

The voltage sensor is configured, for example, from a voltage division resistor, an A/D converter and the like. The voltage sensor detects the voltage between the connecting terminals; that is, the charging voltage of the assembled battery via an electrical wire, and outputs the voltage value to the generator control unit. The current sensor is configured, for instance, from a shunt resistor or a Hall element, an A/D converter and the like. The current sensor detects the charging current that is supplied from the charging current supply circuit to the assembled battery, and outputs the current value to the generator control unit.

The generator control unit comprises, for example, a CPU (Central Processing Unit) for executing predetermined arithmetic processing, a ROM (Read Only Memory) for storing predetermined control programs, a RAM (Random Access Memory) for temporarily storing data, and a peripheral circuit of the foregoing components, and is a control circuit for executing the constant current constant voltage (CCCV) charge by controlling the power current and the power voltage of the charging current supply circuit based on the charging voltage obtained from the voltage sensor and the charging current obtained from the current sensor as a result of executing the control programs stored in the ROM.

The charging voltage upon charging the lead storage battery based on a constant voltage charge is generally 14.5V to 15.5V. Thus, upon performing the constant voltage charge, the generator control unit controls the power current and voltage of the charging current supply circuit so that the detected voltage of the voltage sensor becomes 14.5V to 15.5V.

Meanwhile, the open voltage of the lithium ion secondary battery in a fully charged state is approximately 4.2V. With a nonaqueous secondary battery such as a lithium ion secondary battery, the positive electrode potential and the negative electrode potential decreases pursuant to the increase in the depth of charge resulting from the charge. The terminal voltage of the lithium ion secondary battery appears as the difference between the positive electrode potential and the negative electrode potential. The difference between the positive electrode potential and the negative electrode potential when the negative electrode potential decreases and the negative electrode potential becomes 0V pursuant to the increase in the depth of charge; that is, the positive electrode potential will not be affected by the charging current value, temperature, and variation in the composition of the active materials of the positive electrode and the negative electrode, but it is known that the it is approximately 4.2V when using lithium cobalt oxide as the positive electrode active material, and approximately 4.3V when using lithium manganese oxide as the positive electrode active material. As described above, a full charge is realized when the negative electrode potential becomes 0V, and, as a result of using the terminal voltage at this time, 4.2V for example, as the charging voltage in the constant voltage charge, the lithium ion secondary battery can be fully charged (depth of charge: 100%).

Meanwhile, an aqueous secondary battery such as a nickel hydride secondary battery possesses characteristics of showing an approximately constant terminal voltage in relation to changes in the depth of charge and, for example, the open voltage of the nickel hydride secondary battery in a fully charged state is approximately 1.4V.

Such being the case, with the power supply system 7, for example, if the constant voltage charge of the assembled battery is performed with the charging voltage at 14.5V, the charging voltage of each of the lithium ion secondary batteries 2a, 2b and 2c will be (14.5V - (1.4V $\times$ 2))/3 = 3.9V. Thus, it will be possible to raise the charging voltage of the lithium ion secondary batteries 2a, 2b and 2c to be higher than the charging voltage of 3.63V per lithium ion secondary battery in cases where four lithium ion secondary batteries are serially connected as described above.

Specifically, in comparison to the voltage of 16.8V obtained by multiplying 4 to 4.2V as the open voltage of the lithium ion secondary battery in a fully charged state, with the total voltage of 15.4V of a voltage obtained by multiplying 3 to 4.2V as the open voltage of the lithium ion secondary battery in a fully charged state and a voltage obtained by multiplying 2 to 1.4V as the open voltage of the nickel hydride secondary battery in a fully charged state, the difference with the charging voltage of 14.5V for the lead storage battery will be smaller. In the foregoing case, the depth of charge of the lithium ion secondary batteries 2a, 2b and 2c at the end of charge will be approximately 73%, and the depth of charge of the lithium ion secondary batteries 2a, 2b and 2c at the end of charge can be increased.

Moreover, since the foregoing total voltage is not less than the charging voltage of 14.5V for the lead storage battery, if the charging voltage for the lead storage battery is applied between the connecting terminals, the charging voltage that is applied to each lithium ion secondary battery will be 4.2V or less. Consequently, in addition to being able to reduce the deterioration of the lithium ion secondary battery, it is possible to reduce the possibility of the safety becoming impaired.

The power voltages of the lead storage battery include multiples of 12V such as 12V, 24V, and 42V, and the charging voltage of the charging circuit for charging the lead storage battery is also a multiple of 14.5V to 15.5V. Thus, with the assembled battery in which two nickel hydride batteries and three lithium ion secondary batteries having a smaller battery capacity than the nickel hydride batteries are serially connected as one unit (single unit), it is desirable to make the ratio of the number of nickel hydride secondary batteries and the number of lithium ion secondary batteries to be 2:3 by increasing or decreasing the number of units according to the charging voltage of the charging circuit. Thereby, as with the case of the power voltage of the lead storage battery being 12V, the charging voltage of the assembled battery can be adapted to the power voltage of the charging circuit, and the depth of charge at the end of charge upon charging the assembled battery 1 can be increased by using this kind of charging circuit.

With the unit configured above as the basic unit, it is also possible to configure an assembled battery connecting several units based on serial connection, parallel connection, or a combination of serial and parallel connections in compliance with demands such as electromotive force or battery capacity.

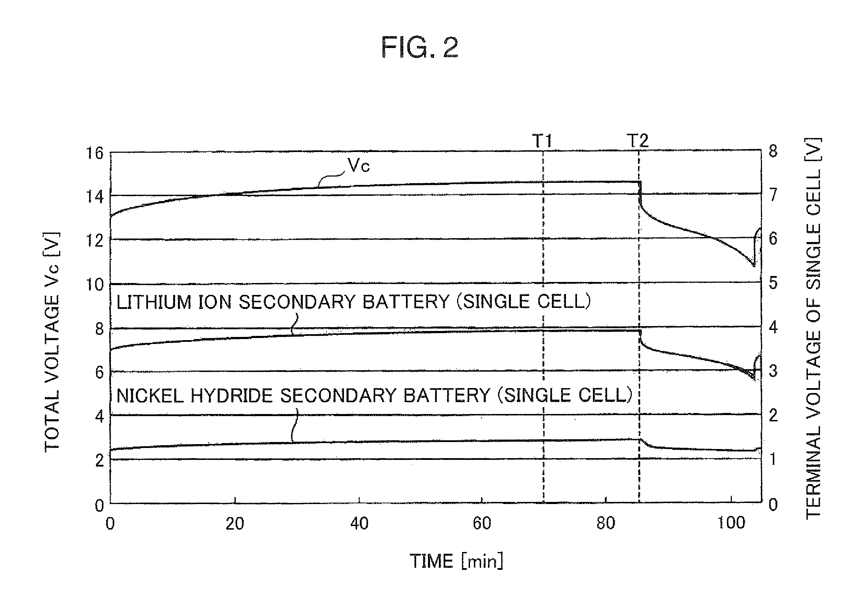

The operation of the power supply system 7 configured as described above is now explained. Fig. 2 is a graph showing an example of the charging time, and the terminal voltage of the respective lithium ion secondary batteries and the respective nickel hydride secondary batteries, and the voltage between the connecting terminals; that is, the total voltage (Vc) upon subjecting the assembled battery to constant current constant voltage charge (CCCV) with the generator 1 shown in Fig. 1. The horizontal axis shows the charging time, the right side vertical axis shows the terminal voltage of a single cell of the lithium ion secondary batteries 2a, 2b and 2c and the nickel hydride secondary batteries 2d and 2e, and the left side vertical axis shows the total voltage Vc.

Foremost, the charging current of 2A is output from the charging current supply circuit to the assembled battery via an electrical wire according to a control signal from the generator control unit, and the assembled battery is subject to a constant current charge at 2A. Then, the terminal voltage of the respective lithium ion secondary batteries 2a, 2b and 2c and the respective nickel hydride secondary batteries 2d and 2e will rise pursuant to the charging, and the total voltage Vc will also rise.

Here, charging is performed with the terminal voltage of the nickel hydride secondary batteries 2d and 2e only rising slightly, and being approximately constant. Meanwhile, the terminal voltage of the lithium ion secondary batteries 2a, 2b and 2c will increase in an ascending curve pursuant to the charge. Then, the total voltage Vc will increase in accordance with the increase of the terminal voltage of the lithium ion secondary batteries 2a, 2b and 2c.

When the total voltage Vc detected by the voltage sensor reaches 14.5V (timing T1), the generator control unit switches the constant current charge to the constant voltage charge. Then, in accordance with a control signal from the generator control unit, the charging current supply circuit executes the constant voltage charge by applying a constant voltage of 14.5V between the connecting terminals.

Then, the charging current will decrease pursuant to the increase in the depth of charge of the lithium ion secondary batteries 2a, 2b and 2c resulting from the constant voltage charge. Subsequently, when the charging current detected by the current sensor falls below the charge cut-off current that was pre-set as the cut-off condition of the constant voltage charge, it is determined that the generator control unit has charged the lithium ion secondary batteries 2a, 2b and 2c up to a depth of charge that is close to the maximum depth of charge that can be charged in the constant voltage charge of 14.5V. Then, according to a control signal from the generator control unit, the power current of the charging current supply circuit becomes zero and the charge is thereby ended (timing T2).

Meanwhile, since the three lithium ion secondary batteries 2a, 2b and 2c and the two nickel hydride secondary batteries 2d and 2e are serially connected, the charring current that is supplied to the respective batteries is equal. Then, since the lithium ion secondary batteries 2a, 2b and 2c with a small battery capacity will approach a full charge before the nickel hydride secondary batteries 2d and 2e with a large battery capacity, at timing T2, the depth of charge of the nickel hydride secondary batteries 2d and 2e will become shallower than the depth of charge of the lithium ion secondary batteries 2a, 2b and 2c.

For example, in cases where the battery capacity of the lithium ion secondary batteries 2a, 2b and 2c is 80% of the nickel hydride secondary batteries 2d and 2e, and the depth of charge of the lithium ion secondary batteries 2a, 2b and 2c becomes 100%, the depth of charge of the nickel hydride secondary batteries 2d and 2e will become 80%. Then, by making the battery capacity of the lithium ion secondary batteries 2a, 2b and 2c to be smaller than the battery capacity of the nickel hydride secondary batteries 2d and 2e, since the nickel hydride secondary batteries 2d and 2e will no longer exceed the full charge (depth of charge 100%) at the timing T2 that the lithium ion secondary batteries 2a, 2b and 2c are charged close to full charge (depth of charge 100%) and the constant voltage charge is ended, the depth of charge of the lithium ion secondary batteries 2a, 2b and 2c at the end of charge can be increased while reducing the possibility of the nickel hydride secondary batteries 2d and 2e becoming overcharged.

Moreover, since the charge will end before the nickel hydride secondary batteries 2d and 2e generates heat near its full charge, the possibility of the lithium ion secondary batteries 2a, 2b and 2c deteriorating due to the heat generated by the nickel hydride secondary batteries 2d and 2e near its full charge can be reduced.

Further, the nickel hydride secondary batteries 2d and 2e have characteristics in which the charging current increases near the full charge when subject to a constant voltage charge. Thus, if the battery capacity of the nickel hydride secondary batteries 2d and 2e is smaller than the battery capacity of the lithium ion secondary batteries 2a, 2b and 2c, the nickel hydride secondary batteries 2d and 2e will approach full charge and the charging current will increase before the lithium ion secondary batteries 2a, 2b and 2c approach full charge and the charging current decreases, and the charging current detected by the current sensor falls below the charge cut-off current. Thus, the charging current will fall below the charge cut-off current. Consequently, the charging will continue without the constant voltage charge ending, and the lithium ion secondary batteries 2a, 2b and 2c and the nickel hydride secondary batteries 2d and 2e will become overcharged and deteriorate the battery characteristics or impair the safety.

Nevertheless, with the assembled battery according to the present embodiment, since the lithium ion secondary batteries 2a, 2b and 2c have a smaller battery capacity than the nickel hydride secondary batteries 2d and 2e, the constant voltage charge can be ended before the nickel hydride secondary batteries 2d and 2e approach full charge and the charging current increases. Consequently, the possibility of the battery deteriorating and the safety being impaired can be reduced.

Meanwhile, it is known that the self discharge current of the nickel hydride secondary batteries 2d and 2e is greater than the lithium ion secondary batteries 2a, 2b and 2c. Thus, if the assembled battery is neglected after it is charged, the residual capacity of the nickel hydride secondary batteries 2d and 2e will become less than the residual capacity of the lithium ion secondary batteries 2a, 2b and 2c. Then, if the charging of the assembled battery 1 is started in a state where the residual capacity of the nickel hydride secondary batteries 2d and 2e is less than the residual capacity of the lithium ion secondary batteries 2a, 2b and 2c, the charging capacity of the overall assembled battery 1 will decrease since the charging capacity of the nickel hydride secondary batteries 2d and 2e at the end of charge will decrease in the amount of the capacity that had decreased due to the self discharge before the charging.

Here, the inventors of the present invention experimentally discovered that the self discharge of the nickel hydride secondary batteries 2d and 2e will decrease if the charging is ended in a state where the depth of charge of the nickel hydride secondary batteries 2d and 2e is low. Such being the case, if the assembled battery is subject to a constant voltage charge, the lithium ion secondary batteries 2a, 2b and 2c will approach full charge before the charging current increases when the depth of charge of the nickel hydride secondary batteries 2d and 2e is in a low-lying state. Consequently, since the charging will end as a result of the charging current decreasing and falling below the charge cut-off current, the charging will automatically end in a state where the depth of charge of the nickel hydride secondary batteries 2d and 2e is low. As a result, it is possible to reduce the self discharge of the nickel hydride secondary batteries 2d and 2e. If the self discharge of the nickel hydride secondary batteries 2d and 2e decreases, the decrease in the charging capacity of the overall assembled battery that is caused by the self discharge of the nickel hydride secondary batteries 2d and 2e can be reduced.

In addition to combining the lithium ion secondary batteries 2a, 2b and 2c and the nickel hydride secondary batteries 2d and 2e as described above, the power supply system 7 according to the present embodiment comprises a plurality of forced discharge units (configured from a switch 3a, 3b or 3c, a resistor 4a, 4b or 4c, and a diode 5a, 5b or 5c) capable of forcibly discharging the lithium ion secondary batteries 2a, 2b and 2c individually, and a control unit 6 for individually measuring the voltage of the lithium ion secondary batteries 2a, 2b and 2c and, when the voltage of the lithium ion secondary batteries 2a, 2b and 2c reaches the forced discharge start voltage Va, forcibly discharging the lithium ion secondary batteries 2a, 2b and 2c individually by using the forced discharge unit until the forced discharge end voltage Vb is reached.

The depth of charge (SOC) of the lithium ion secondary batteries 2a, 2b and 2c will change depending on the rated voltage of the generator 1. [Table 1] shows the relation of the rated voltage and SOC of the generator 1 per lithium ion secondary battery as a cell based on Fig. 2.

[Table 1]

| Rated voltage per cell (V) | 4.2 | 4.15 | 4.1 | 4.05 | 4.0 | 3.95 | 3.9 | 3.85 | 3.8 |
|---|---|---|---|---|---|---|---|---|---|
| SOC (%) | 100 | 95.5 | 91 | 86.5 | 82 | 77.5 | 73 | 68.5 | 64 |

For example, if the rated voltage of the generator 1 is 3.9V per lithium ion secondary battery, the SOC (sought by dividing the charging capacity in which the rated voltage per cell is 3.9V by the charging capacity in which the rated voltage per cell is 4.2V) will be 73%, but if the rated voltage of the generator 1 per lithium ion secondary battery is 4.1V, the SOC will be 91%. With the lithium ion secondary battery, when the SOC after charge approaches 100%, the component (primarily carbonate) of the electrolyte containing a nonaqueous electrolyte will easily decompose. In order to prevent the charging current from the generator 1 from additionally being supplied to the lithium ion secondary battery in the foregoing state, the forced discharge start voltage Va is set to a range that is slightly lower than the voltage in which the SOC after charge approaches 100%, the control unit 6 individually and sequentially measures the voltage of the lithium ion secondary batteries 2a, 2b and 2c, and, when any one of the voltages of the lithium ion secondary batteries 2a, 2b and 2c reaches the forced discharge start voltage Va based on the charge from the generator 1, forcible discharge is performed using the forced discharge unit until the voltage of the corresponding lithium ion secondary battery 2a, 2b or 2c reach the forced discharge end voltage Vb based on a command from the control unit 6.

The operation of the power supply system 7 of the present invention is now further explained taking a case where the lithium ion secondary battery 2a first reaches the forced discharge start voltage Va is now explained.

The control unit 6 is sequentially and individually measuring the lithium ion secondary batteries 2a, 2b and 2c configuring the assembled battery. Charging current is randomly supplied from the generator 1 to the assembled battery. Here, if the lithium ion secondary battery 2a reaches the forced discharge start voltage Va before the lithium ion secondary batteries 2b and 2c as a result of the SOC becoming high due to some kind of contributing factor (for example, difference in weight of the active material contained in the battery), the switch 3a is turned ON while the switches 3b and 3c remain OFF based on a command from the control unit 6, and, while the charging current is supplied to the assembled battery itself, only the cell 2a is subject to forcible discharge until it reaches the forced discharge end voltage Vb through the forced discharge circuit configured from the resistor 4a and the diode 5a. When the forcible discharge is ended, the switch 3a is turned OFF based on a command from the control unit 6, and the lithium ion secondary battery 2a enters a state of being able to receive the charge from the generator 1.

Note that, since the assembled battery configured from the lithium ion secondary batteries 2b and 2c and the nickel hydride secondary batteries 2d and 2e is still receiving the charge from the generator 1 while the lithium ion secondary battery 2a is being subject to forcible discharge, the charging current will not be excessively supplied to the in-car device 8. Moreover, after the forcible discharge of the lithium ion secondary battery 2a is ended, even if the lithium ion secondary battery 2b or 2c reaches the forced discharge start voltage Va and forcible discharge is started, since at least the lithium ion secondary battery 2a is of a state of being able to receive the charge from the generator 1, the charging current will not be excessively supplied to the in-car device 8.

Specifically, the lithium ion secondary batteries 2a, 2b and 2c and the nickel hydride secondary batteries 2d and 2e are serially connected, respectively. Moreover, the forced discharge unit is provided to the respective lithium ion secondary batteries 2a, 2b and 2c, and is a circuit for connecting the positive electrode terminal and the negative electrode terminal of the respective lithium ion secondary batteries. Then, the control unit 6 controls the operation of the respective switches so that all switches 3a, 3b and 3c are of a disconnected state until any one of the lithium ion secondary batteries 2a, 2b and 2c reaches the forced discharge start voltage Va while the assembled battery is being charged. Moreover, when any one of the lithium ion secondary batteries 2a, 2b and 2c reaches the forced discharge start voltage Va, the control unit 6 starts the forcible discharge by connecting only the switch corresponding to the lithium ion secondary battery that reached the forced discharge start voltage Va on the one hand, and maintains the disconnected state of the other switches. Specifically, the control unit 6 controls the operation of the respective switches so that the lithium ion secondary batteries and the nickel hydride secondary batteries 2d and 2e that are not being subject to forcible discharge will be continued while forcible discharge is being performed to any one of the lithium ion secondary batteries 2a, 2b and 2c.

As described above, the power supply system 7 of this embodiment yields the effect of being able to avoid overcurrent from flowing to the load connected to the power supply system 7 such as an in-car device 8 and prevent such load from malfunctioning since the assembled battery will constantly receive the charge from the generator 1.

Moreover, preferably, the lithium ion secondary batteries 2a, 2b and 2c and the nickel hydride secondary batteries 2d and 2e have a different terminal in the fully charged state.

According to the foregoing configuration, the assembled battery is configured by combining two types of batteries having a different terminal voltage in the fully charged state. With the constant voltage charge, since the charging voltage per cell is used as the terminal voltage in the fully charged state, the depth of charge at the end of charge of the assembled battery configured by combining two types of batteries having a different terminal voltage in the fully charged state can be easily increased by adapting the charging voltage of the overall assembled battery to a predetermined charging voltage.

Moreover, both ends of the series circuit in which the lithium ion secondary batteries 2a, 2b and 2c and the nickel hydride secondary batteries 2d and 2e are serially connected are provided with a connecting terminal for receiving the charging voltage from the generator 1 that performs constant voltage charge of outputting a predetermined constant charging voltage, and, preferably, with the total voltage of a voltage obtained by multiplying the number of nickel hydride secondary batteries 2d and 2e contained in the series circuit to the terminal voltage in the fully charged state of the nickel hydride secondary batteries 2d and 2e and a voltage obtained by multiplying the number of lithium ion secondary batteries 2a, 2b and 2c contained in the series circuit to the terminal voltage in the fully charged state of the lithium ion secondary batteries 2a, 2b and 2c, the difference with the charging voltage is smaller than with the voltage that is closest to the charging voltage among the voltages obtained by performing integral multiplication to the terminal voltage in the fully charged state of the lithium ion secondary batteries 2a, 2b and 2c.

According to the foregoing configuration, the difference between the total voltage of a voltage obtained by multiplying the number of nickel hydride secondary batteries 2d and 2e contained in the series circuit to the terminal voltage in the fully charged state of the nickel hydride secondary batteries 2d and 2e and a voltage obtained by multiplying the number of lithium ion secondary batteries 2a, 2b and 2c contained in the series circuit to the terminal voltage in the fully charged state of the lithium ion secondary batteries 2a, 2b and 2c; that is, the charging voltage that is originally required for fully charging the assembled battery, and the charging voltage supplied from the generator 1 will be smaller than the voltage that is supplied from the generator 1 and is closest to the charging voltage among the voltages obtained by performing integral multiplication to the terminal voltage in the fully charged state of the lithium ion secondary batteries 2a, 2b and 2c. Thus, when the assembled battery is subject to constant voltage charge by the generator 1, in comparison to cases of subjecting the assembled battery configured only from the lithium ion secondary batteries 2a, 2b and 2c to constant voltage charge by the generator 1, the assembled battery can be charge to a voltage that is closer to full charge; that is, the depth of charge at the end of charge can be increased.

Moreover, the total voltage is set to be not less than the charging voltage, and the difference thereof with the charging voltage is smaller than with the voltage that is not less than the charging voltage and is closest to the charging voltage among the voltages obtained by performing integral multiplication to the terminal voltage in the fully charged state of the lithium ion secondary battery.

According to the foregoing configuration, since the total voltage; that is, the charging voltage that is originally required for fully charging the assembled battery is greater than the charging voltage supplied from the generator 1, the possibility of an overvoltage being supplied to the assembled battery when the assembled battery is subject to constant voltage charge by the generator 1 can be reduced.

Moreover, the generator 1 is a generator for a lead storage battery, and the number of the nickel hydride secondary batteries and the number of the lithium ion secondary batteries contained in the series circuit are preferably set to be a ratio of 2:3.

According to the foregoing configuration, the depth of charge at the end of charge can be increased by reducing the difference between the charging voltage supplied from the generator for a lead storage battery and the charging voltage that is required for fully charging the assembled battery.

Moreover, with a unit configured from two of the aqueous secondary batteries and three of the nonaqueous secondary batteries as the basic unit, a plurality of the units are configured based on serial connection, parallel connection, or a combination of serial and parallel connections.

Moreover, when adopting lithium composite oxide containing cobalt as an active material of a positive electrode of the lithium ion secondary battery, this is preferably since the slope of the charging voltage of the lithium ion secondary battery will become great and the voltage can be controlled easily.

Moreover, according to the configuration wherein the forced discharge unit is configured from a forced discharge circuit made up of resistors 4a, 4b and 4c and diodes 5a, 5b and 5c, and switches 3a, 3b and 3c for connecting the lithium ion secondary batteries 2a, 2b and 2c to the forced discharge circuit based on a command from the control unit 6, it is possible to perform the discharge with improved safety while restricting the discharge current.

Moreover, preferably, the forced discharge start voltage Va is set to 4.05V or more and 4.15V or less for each of the lithium ion secondary batteries. If the forced discharge start voltage Va is set to less than 4.05V, this is not preferable since the amount of charge acceptance of the lithium ion secondary battery will be too small, and if it is set to exceed 4.15V, this is not preferable since the forcible discharge of the lithium ion secondary battery will not start until approaching an overcharge range.

Moreover, preferably, the forced discharge end voltage Vb is set to 3.85V or more and 3.95V or less for each of the lithium ion secondary batteries. If the forced discharge end voltage Vb is set to less than 3.85V, this is not preferable since the quantity of electrify to be forcibly discharged will become excessive (forced discharge time per implementation will become long) and the charging current from the generator 1 will constantly be received with few lithium ion secondary batteries, and if it is set to exceed 3.95V, this is not preferable since the amount of charge acceptance of the lithium ion secondary battery will be too small.

Moreover, preferably, forcible discharge is performed for a given period of time at a constant current value so as to achieve the quantity of electricity that is required for the forcible discharge calculated from the forced discharge start voltage Va and the forced discharge end voltage Vb. Instead of performing forcible discharge while sequentially measuring the voltage when the lithium ion secondary battery 2a, 2b or 2c reaches the forced discharge start voltage Va until the lithium ion secondary battery 2a, 2b or 2c reaches the forced discharge end voltage Vb, the method of calculating the difference of the depth of charge from the difference between the forced discharge start voltage Va and the forced discharge end voltage Vb and comprehending the quantity of electricity of forcibly discharging the lithium ion secondary battery 2a, 2b or 2c, and performing forcible discharge for a given period at a constant current value will allow a more simple and accurate method of forcibly discharging the lithium ion secondary battery.

Specifically, when the depth of charge obtained by converting the forced discharge start voltage Va and the forced discharge end voltage Vb is Sa, Sb, a full charge capacity for each of the lithium ion secondary battery 2a, 2b or 2c is Fcc, and a predetermined discharge current in consideration of safety of heat generation is Id, then the discharge time is Td (sec) can be obtained from the following Formula (1):

$$Td = Fcc \times (Sa\text{-}Sb)/Id \qquad (1)$$

The generator 1 is not limited to a generator for a lead storage battery. An assembled battery that is charged by a generator for performing constant voltage charge with an arbitrary charging voltage can be applied by suitably setting the number of lithium ion secondary batteries and the nickel hydride secondary batteries.

Examples

CGR18650DA (battery capacity 2.45Ah) manufactured by Matsushita Battery Industrial Co., Ltd. was used as the lithium ion secondary battery, and HHR260SCP (battery capacity 2.6Ah) manufactured by Matsushita Battery Industrial Co., Ltd. or HHR200SPC (battery capacity 2.1Ah) manufactured by Matsushita Battery Industrial Co., Ltd. was used as the nickel hydride secondary battery, and the assembled batteries shown in Examples 1 to 3, Reference Example 1, and Comparative Example 2 were created. Moreover, in Comparative Example 1, LC-P122R2J (battery capacity 2.2Ah) manufactured by Matsushita Battery Industrial Co., Ltd. was used as the lead storage battery.

(Example 1)

An assembled battery configured by serially connecting a total of five cells; namely, three cells of CGR18650DA (battery capacity 2.45Ah) and two cells of HHR260SCP (battery capacity 2.6Ah) was used to configure a power supply system containing a forced discharge unit and a control unit as with Fig. 1 and used as Example 1. Here, excluding one arbitrary cell of the CGR18650DA (battery capacity 2.45Ah) having a charging capacity of 1Ah, the remaining four cells were of a full discharge state upon configuring the assembled battery, and the forced discharge start voltage Va was set to 4.1V and the forced discharge end voltage Vb was set to 3.9V.

(Example 2)

An assembled battery configured by serially connecting a total of six cells; namely, three cells of CGR18650DA (battery capacity 2.45Ah) and three cells of HHR260SCP (battery capacity 2.6Ah) was used to configure the a similar power supply system as with Example 1, and used as Example 2. Here, excluding one arbitrary cell of the CGR18650DA (battery capacity 2.45Ah) having a charging capacity of 1Ah, the remaining five cells were of a full discharge state upon configuring the assembled battery, and the forced discharge start voltage Va was set to 4.1V and the forced discharge end voltage Vb was set to 3.9V.

(Example 3)

An assembled battery configured by serially connecting a total of seven cells; namely, two cells of CGR18650DA (battery capacity 2.45Ah) and five cells of HHR260SCP (battery capacity 2.6Ah) was used to configure a similar power supply system as with Example 1, and used as Example 3. Here, excluding one arbitrary cell of the CGR18650DA (battery capacity 2.45Ah) having a charging capacity of 1Ah, the remaining six cells were of a full discharge state upon configuring the assembled battery, and the forced discharge start voltage Va was set to 4.1V and the forced discharge end voltage Vb was set to 3.9V.

(Reference Example 1)

The forced discharge unit and the control unit as with Fig. 1 was removed from the power supply system of Example 1 to configure a power supply system, and used as Reference Example 1.

(Comparative Example 1)

One cell of LC-P122R2J (battery capacity 2.2Ah) was used as the assembled battery of Comparative Example 1.

(Comparative Example 2)

A total of five cells; namely, three cells of CGR18650DA (battery capacity 2.45Ah) and two cells of HHR200SPC (battery capacity 2.1Ah) were serially connected and used as the assembled battery of Comparative Example 2.

After performing constant current constant voltage charge to the Examples 1 to 3, Reference Example 1, and Comparative Examples 1 and 2 under the conditions of charging current 1A in the constant current charge, charging voltage 5V in the constant voltage charge, and charge cut-off current 0.1A, the battery energy density per volume and the battery energy density per weight of the assembled battery upon discharging up to 10V with the constant current 1A were measured. Moreover, the battery energy density per volume and the battery energy density per weight of the assembled battery after repeating the foregoing charge-discharge 300 times were measured. Moreover, for Examples 1 to 3 and Reference Example 1, the appearance of CGR18650DA (battery capacity 2.45Ah) that was charged redundantly after repeating the foregoing charge-discharge 300 times was observed.

The results are shown in [Table 2].

[Table 2]

| | | Initially | | After 300 cycles | | |
|---|---|---|---|---|---|---|
| | | Volume energy density (Wh/L) | Weight energy density (Wh/kg) | Volume energy density (Wh/L) | Weight energy density (Wh/kg) | Appearance |
| | Example 1 | 322 | 112 | 306 | 106 | No abnormality |
| | Example 2 | 137 | 47 | 130 | 45 | No abnormality |
| | Example 3 | 211 | 70 | 200 | 67 | No abnormality |
| | Reference Example 1 | 322 | 112 | 34 | 12 | Leakage |
| | Comparative Example 1 | 73 | 33 | 51 | 23 | - |
| | Comparative Example 2 | 357 | 127 | 89 | 32 | - |

As shown in Table 2, Examples 1 to 3 and Reference Example 1 of the present invention which combines nickel hydride secondary batteries and lithium ion secondary batteries having a capacity that is smaller than the battery capacity of the nickel hydride secondary batteries have sufficiently large battery energy density per volume and battery energy density per weight of the assembled battery in comparison to the lead storage battery of Comparative Example 1, and lighter weight and miniaturization are possible. Moreover, with Reference Example 1, although leakage of electrolyte was observed from CGR18650DA (battery capacity 2.45Ah) that was redundantly charged after 300 cycles, no abnormality could be appeared in the appearance of Examples 1 to 3 of the present invention.

In Examples 1 to 3 of the present invention, it is considered that, since the control unit individually measured the voltage of the lithium ion secondary batteries and, when the voltage of any one of the lithium ion secondary batteries reached the forced discharge start voltage Va, performed forcible discharge to the corresponding lithium ion secondary battery using a forced discharge unit until reaching the forced discharge end voltage Vb, even if a specific lithium ion secondary battery was redundantly charged and the SOC was intentionally varied, the inconvenience of Reference Example 1 did not arise. As a result of this effect, with Examples 1 to 3 of the present invention, the battery energy density per volume and the battery energy density per weight of the assembled battery after 300 cycles were sufficiently larger in comparison to Comparative Examples 1 and 2 in addition to Reference Example 1, and it is evident that deterioration caused by repeated use can be reduced.

Incidentally, the specific embodiments described above primarily include the invention configured as described below.

The power supply system according to one aspect of the present invention includes at least one aqueous secondary battery and at least one nonaqueous secondary battery having a smaller per-unit battery capacity than the aqueous secondary battery, wherein the aqueous secondary battery and the nonaqueous secondary battery are serially connected. The power supply system further includes at least one forced discharge unit capable of forcibly discharging each nonaqueous secondary battery, and a control unit for individually measuring the voltages of the nonaqueous secondary battery and the aqueous secondary battery, and when the voltage of the nonaqueous secondary battery reaches a forced discharge start voltage Va, forcibly discharging each nonaqueous secondary battery using the forced discharge unit until a forced discharge end voltage Vb is reached.

According to the foregoing configuration, when the assembled battery configured from an aqueous secondary battery and a nonaqueous secondary battery is charged based on a constant voltage charge, since the charging current flowing in the aqueous secondary battery and the charging current flowing in the nonaqueous secondary battery are equal, the nonaqueous secondary battery with a smaller battery capacity will approach full charge first, the charging current will decrease, and the constant voltage charge will end. Then, at the time when the charging is ended, since the aqueous secondary battery having a larger battery capacity than the nonaqueous secondary battery has not yet reached full charge, the possibility of its overcharge can be reduced. Moreover, in comparison to cases of serially connecting a plurality of secondary batteries of the same type, with the combination of the aqueous secondary battery and the nonaqueous secondary battery having different battery characteristics, it will be easier to adapt the charging characteristics of the overall assembled battery to a predetermined charging voltage and increase the depth of charge at the end of the charge.

In addition, with the power supply system of the present invention, a control unit individually measures the voltages of the nonaqueous secondary battery and the aqueous secondary battery, and when the voltage of the nonaqueous secondary battery reaches a forced discharge start voltage Va, forcibly discharges the nonaqueous secondary batteries using the forced discharge unit until a forced discharge end voltage Vb is reached. If the aqueous secondary battery configuring the assembled battery is subject to a voltage drop due to a short circuit or the like, if the constant voltage charge to the assembled battery is continued, there is a possibility that the nonaqueous secondary battery configuring the assembled battery may be overcharged. According to the power supply system of the present invention, even if the foregoing problem occurs, since the nonaqueous secondary battery can be controlled so that it will not exceed the forced discharge start voltage Va, greater safety can be ensured.

In the foregoing configuration, preferably, the aqueous secondary battery and the nonaqueous secondary battery have a different terminal voltage in the fully charged state.

According to the foregoing configuration, the assembled battery is configured by combining two types of batteries having a different terminal voltage in the fully charged state. With the constant voltage charge, since the charging voltage per cell is used as the terminal voltage in the fully charged state, the depth of charge at the end of charge of the assembled battery configured by combining two types of batteries having a different terminal voltage in the fully charged state can be easily increased by adapting the charging voltage of the overall assembled battery to a predetermined charging voltage.

In the foregoing configuration, preferably, both ends of a series circuit in which the aqueous secondary battery and the nonaqueous secondary battery are serially connected are provided with a connecting terminal for receiving the charging voltage from a generator that performs constant voltage charge for outputting a predetermined constant charging voltage, and the total voltage of a voltage obtained by multiplying the number of aqueous secondary batteries contained in the series circuit to the terminal voltage in the fully charged state of the aqueous secondary battery and a voltage obtained by multiplying the number of aqueous secondary batteries contained in the series circuit to the terminal voltage in the fully charged state of the nonaqueous secondary battery, and the charging voltage has a smaller difference from the charging voltage than the voltage that is closest to the charging voltage among the voltages obtained by performing integral multiplication to the terminal voltage in the fully charged state of the nonaqueous secondary battery.

According to the foregoing configuration, the difference between the total voltage of a voltage obtained by multiplying the number of aqueous secondary batteries contained in the series circuit to the terminal voltage in the fully charged state of the aqueous secondary battery and a voltage obtained by multiplying the number of aqueous secondary batteries contained in the series circuit to the terminal voltage in the fully charged state of the nonaqueous secondary battery; that is, the charging voltage that is originally required for fully charging the assembled battery, and the charging voltage supplied from the generator will be smaller than the voltage that is closest to the charging voltage among the voltages obtained by performing integral multiplication to the terminal voltage in the fully charged state of the nonaqueous secondary battery. Thus, when the assembled battery is subject to constant voltage charge by the generator, in comparison to cases of subjecting the assembled battery configured only from the nonaqueous secondary batteries to constant voltage charge by the generator, the assembled battery can be charge to a voltage that is closer to full charge; that is, the depth of charge at the end of charge can be increased.

In the foregoing configuration, preferably, the total voltage is set to be not less than the charging voltage, and the difference thereof from the charging voltage is smaller than the voltage that is not less than the charging voltage and is closest to the charging voltage among the voltages obtained by performing integral multiplication to the terminal voltage in the fully charged state of the nonaqueous secondary battery.

According to the foregoing configuration, since the total voltage; that is, the charging voltage that is originally required for fully charging the assembled battery is greater than the charging voltage supplied from the generator, the possibility of an overvoltage being supplied to the assembled battery when the assembled battery is subject to constant voltage charge by the generator can be reduced.

In the foregoing configuration, preferably, the generator is a generator for a lead storage battery, and the number of the aqueous secondary batteries and the number of the nonaqueous secondary batteries contained in the series circuit are set to be a ratio of 2:3.

According to the foregoing configuration, the depth of charge at the end of charge can be increased by reducing the difference between the charging voltage supplied from the generator for a lead storage battery and the charging voltage that is required for fully charging the assembled battery.

Moreover, preferably, the aqueous secondary battery is a nickel hydride secondary battery. Since the nickel hydride secondary battery has high energy density even among the aqueous secondary batteries, the still ligher weight and miniaturization of the assembled battery can be realized.

Further, preferably, the nonaqueous secondary battery is a lithium ion secondary battery. Since the lithium ion secondary battery has high energy density even among the nonaqueous secondary batteries, the still lighter weight and miniaturization of the assembled battery can be realized.

In addition, preferably, lithium composite oxide containing cobalt is used as an active material of a positive electrode of the nonaqueous secondary battery since the slope of the charging voltage of the nonaqueous secondary battery will become great and the voltage can be easily controlled.

In the foregoing configuration, preferably, the forced discharge unit is configured from a forced discharge circuit formed from a resistor and a diode, and a switch for connecting the nonaqueous secondary battery to the forced discharge circuit based on a command from the control unit. According to the foregoing configuration, the discharge current can be restricted and discharge can be safely performed.

In the foregoing configuration, preferably, the nonaqueous secondary battery and the aqueous secondary battery are respectively serially connected, the forced discharge unit is a circuit that is provided to each of the nonaqueous secondary batteries and that connects a positive electrode terminal and a negative electrode terminal of each of the nonaqueous secondary batteries, during the charge, the control unit sets all of the switches to a disconnected state until any one of the nonaqueous secondary batteries reaches a forced discharge start voltage Va, and when any of the nonaqueous secondary batteries reaches a forced discharge start voltage Va, the control unit connects only the switch corresponding to the nonaqueous secondary battery that has reached the forced discharge start voltage Va and starts the forcible discharge, and meanwhile maintains the disconnected state of the other switches and controls the operation of the respective switches so that, even during the forcible discharge, the charge of the nonaqueous secondary battery and the aqueous secondary battery which are not subject to the forcible discharge is continued.

According to the foregoing configuration, the control unit controls the operation of the respective switches so that the nonaqueous secondary batteries and the aqueous secondary batteries that are not being subject to forcible discharge will be continued while forcible discharge is being performed to any one of the nonaqueous secondary batteries. Thereby, the power supply system is able to avoid overcurrent from flowing to the load connected to the power supply system such and prevent such load from malfunctioning since the assembled battery will constantly receive the charge from the generator.

In the foregoing configuration, preferably, the forced discharge start voltage Va is set to 4.05V or more and 4.15V or less for each of the nonaqueous secondary batteries. If the forced discharge start voltage Va is set to less than 4.05V, this is not preferable since the amount of charge acceptance of the nonacqueous secondary battery will be too small, and if it is set to exceed 4.15V, this is not preferable since the forcible discharge of the nonacqueous secondary battery will not start until approaching an overcharge range.

In the foregoing configuration, preferably, the forced discharge end voltage Vb is set to 3.85V or more and 3.95V or less for each of the nonaqueous secondary batteries. If the forced discharge end voltage Vb is set to less than 3.85V, this is not preferable since the quantity of electrify to be forcibly discharged will become excessive (forced discharge time per implementation will become long) and the charging current from a battery charger will constantly be received with few nonacqueous secondary batteries, and if it is set to exceed 3.95V, this is not preferable since the amount of charge acceptance of the nonacqueous secondary battery will be too small.

In the foregoing configuration, preferably, when a depth of charge obtained by converting from a forced discharge start voltage Va is Sa, a depth of charge obtained by converting from a forced discharge end voltage Vb is Sb, a full charge capacity for each of the nonaqueous secondary batteries is Fcc, a constant discharge current flowing during the forcible discharge of the nonaqueous secondary battery is Id, and a discharge time is Td, the forcible discharge is performed at a constant discharge current Id for a given discharge time Td (sec) so as to satisfy following Formula (1):

$$Td = Fcc \times (Sa-Sb)/Id \qquad (1)$$

According to the foregoing configuration, instead of performing forcible discharge while sequentially measuring the voltage when the nonaqueous secondary battery reaches the forced discharge start voltage Va until the nonaqueous secondary battery reaches the forced discharge end voltage Vb, the method of calculating the difference of the depth of charge from the difference between the forced discharge start voltage Va and the forced discharge end voltage Vb and comprehending the quantity of electricity of forcibly discharging the nonaqueous secondary battery, and performing forcible discharge for a given period at a constant current value will allow a more simple and accurate method of forcibly discharging the nonaqueous secondary battery.

As described above, according to the present invention, it is possible to provide a power supply system that is light in weight, compact, and will not deteriorate easily even after repeated use and which can be easily mounted on vehicles without having to change the generator in substitute for a lead storage battery.

Industrial Applicability

The present invention can be suitably used as an assembled battery that is used as a vehicle battery of two-wheeled vehicles, four-wheeled vehicles as well as construction vehicles, and as an assembled battery that is used as the power source of electronic devices such as portable personal computers, digital cameras and cell phones, and vehicles such as electrical vehicles and hybrid cars. The present invention can also be suitably used as a power supply using such an assembled battery.

**Claims**

1. A power supply system comprising at least one aqueous secondary battery; and at least one nonaqueous secondary battery having a smaller per-unit battery capacity than the aqueous secondary battery, said power supply system further comprising:

   at least one forced discharge unit capable of forcibly discharging each nonaqueous secondary battery; and
   a control unit for individually measuring the voltage of the nonaqueous secondary battery and, when a voltage of the nonaqueous secondary battery reaches a forced discharge start voltage Va, forcibly discharging each nonaqueous secondary battery using the forced discharge unit until a forced discharge end voltage Vb is reached.

2. The power supply system according to claim 1, wherein the aqueous secondary battery and the nonaqueous secondary battery have a different terminal voltage in a fully charged state.

3. The power supply system according to claim 1 or claim 2, wherein both ends of a series circuit in which the aqueous secondary battery and the nonaqueous secondary battery are serially connected are provided with a connecting terminal for receiving a charging voltage from a generator that performs constant voltage charge for outputting a predetermined constant charging voltage, and wherein the total voltage of a voltage obtained by multiplying the number of aqueous secondary batteries contained in the series circuit to the terminal voltage in the fully charged state of the aqueous secondary battery and a voltage obtained by multiplying the number of nonaqueous secondary batteries contained in the series circuit to the terminal voltage in the fully charged state of the nonaqueous secondary battery, has a smaller difference from the charging voltage than the voltage that is closest to the charging voltage among voltages obtained by performing integral multiplication to the terminal voltage in the fully charged state of the nonaqueous secondary battery.

4. The power supply system according to claim 3, wherein
the total voltage is set to be not less than the charging voltage, and the difference thereof from the charging voltage is smaller than the voltage that is not less than the charging voltage and is closest to the charging voltage among the voltages obtained by performing integral multiplication to the terminal voltage in the fully charged state of the nonaqueous secondary battery.

5. The power supply system according to claim 3 or claim 4, wherein
the generator is a generator for a lead storage battery, and
the number of the aqueous secondary batteries and the number of the nonaqueous secondary batteries contained in the series circuit are set to be a ratio of 2:3.

6. The power supply system according to claim 5, wherein
with a unit that is configured from two of the aqueous secondary batteries and three of the nonaqueous secondary batteries being as a basic unit, a plurality of the units are configured to be connected based on serial connection, parallel connection, or a combination of serial and parallel connections.

7. The power supply system according to any one of claims 1 to 6, wherein the aqueous secondary battery is a nickel hydride secondary battery.

8. The power supply system according to any one of claims 1 to 6, wherein the nonaqueous secondary battery is a lithium ion secondary battery.

9. The power supply system according to claim 8, wherein lithium composite oxide containing cobalt is used as an active material of a positive electrode of the nonaqueous secondary battery.

10. The power supply system according to any one of claims 1 to 9, wherein the forced discharge unit is configured from a forced discharge circuit formed from a resistor and a diode, and a switch for connecting the nonaqueous secondary battery to the forced discharge circuit based on a command from the control unit.

11. The power supply system according to claim 10, wherein
the nonaqueous secondary battery and the aqueous secondary battery are respectively serially connected,
the forced discharge unit is a circuit that is provided to each of nonaqueous secondary batteries and that connects a positive electrode terminal and a negative electrode terminal of each of the nonaqueous secondary batteries,
during the charge, the control unit sets all switches to a disconnected state until any of the nonaqueous secondary batteries reaches a forced discharge start voltage Va, and
wherein
when any of the nonaqueous secondary batteries reaches a forced discharge start voltage Va, the control unit connects only a switch corresponding to the nonaqueous secondary battery that has reached the forced discharge start voltage Va and starts the forcible discharge, and meanwhile maintains the disconnected state of other switches and controls operation of the respective switches so that, even during the forcible discharge, the charge of the nonaqueous secondary battery and the aqueous secondary battery which are not subject to the forcible discharge is continued.

12. The power supply system according to any one of claims 1 to 11, wherein the forced discharge start voltage Va is set to 4.05V or more and 4.15V or less for each of the nonaqueous secondary batteries.

13. The power supply system according to any one of claims 1 to 12, wherein the forced discharge end voltage Vb is set to 3.85V or more and 3.95V or less for each of the nonaqueous secondary batteries.

14. The power supply system according to any one of claims 1 to 13, wherein, when a depth of charge obtained by converting from a forced discharge start voltage Va is Sa, a depth of charge obtained by converting from a forced discharge end voltage Vb is Sb, a full charge capacity for each of the nonaqueous secondary batteries is Fcc, a constant discharge current flowing during the forcible discharge of the nonaqueous secondary battery is Id, and a discharge time is Td,
the forcible discharge is performed at a constant discharge current Id for a given discharge time Td (sec) so as to satisfy following Formula (1):

$$Td = Fcc \times (Sa-Sb)/Id \qquad (1).$$

EP 2 190 101 A1

FIG. 1

16

FIG. 2

**EP 2 190 101 A1**

| **INTERNATIONAL SEARCH REPORT** | International application No. |
|---|---|
| | PCT/JP2008/001908 |

A.  CLASSIFICATION OF SUBJECT MATTER
*H02J7/02(2006.01)i, H01M10/44(2006.01)i*

According to International Patent Classification (IPC) or to both national classification and IPC

B.  FIELDS SEARCHED

Minimum documentation searched (classification system followed by classification symbols)
H02J7/02, H01M10/44, H01M16/00

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2004-32871 A  (Shin-Kobe Electric Machinery Co., Ltd.),<br>29 January, 2004 (29.01.04),<br>Par. Nos. [0014], [0016] to [0026]; Fig. 2<br>(Family: none) | 1,2,8,11-13<br>7,9,10<br>3-6,14 |
| Y | JP 9-180768 A  (Sanyo Electric Co., Ltd.),<br>11 July, 1997 (11.07.97),<br>Par. Nos. [0011], [0016] to [0022]; Fig. 2<br>(Family: none) | 7,9 |
| Y | JP 2001-178003 A  (Hitachi, Ltd.),<br>29 June, 2001 (29.06.01),<br>Par. No. [0010]; Fig. 1<br>(Family: none) | 10 |

☒ Further documents are listed in the continuation of Box C.  ☐ See patent family annex.

| | |
|---|---|
| * Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>    14 August, 2008 (14.08.08) | Date of mailing of the international search report<br>    26 August, 2008 (26.08.08) |
|---|---|
| Name and mailing address of the ISA/<br>    Japanese Patent Office | Authorized officer |
| Facsimile No. | Telephone No. |

Form PCT/ISA/210 (second sheet) (April 2007)

18

**INTERNATIONAL SEARCH REPORT**

International application No.

PCT/JP2008/001908

C (Continuation).    DOCUMENTS CONSIDERED TO BE RELEVANT

| Category* | Citation of document, with indication, where appropriate, of the relevant passages | Relevant to claim No. |
|---|---|---|
| A | JP 9-180767 A (Sanyo Electric Co., Ltd.), 11 July, 1997 (11.07.97), Par. Nos. [0017], [0018]; Fig. 2 (Family: none) | 1-14 |
| A | JP 2002-281687 A (Denso Corp.), 27 September, 2002 (27.09.02), Par. No. [0020]; Fig. 2 (Family: none) | 10-14 |

Form PCT/ISA/210 (continuation of second sheet) (April 2007)

**EP 2 190 101 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H9180768 B